# NEUE EUROPÄISCHE PATENTSCHRIFT

(11) **EP 0 444 538 B2**
(45) Veröffentlichungstag und Bekanntmachung des Hinweises auf die Entscheidung über den Einspruch: **24.04.2002**
(45) Hinweis auf die Patenterteilung: 04.12.1996
(21) Anmeldenummer: 91102573.2
(22) Anmeldetag: 22.02.1991
(51) Int. Cl.: H01J 37/32, C23C 14/32, H01J 37/305, C23C 14/28, C23C 14/30

(54) **Vorrichtung und Verfahren zum Verdampfen von Material im Vakuum sowie Anwendung des Verfahrens**
Device and procedure for vacuum evaporation of a material and utilisation of the procedure
Dispositif et procédé d'évaporation d'un matériau sous vide et utilisation du procédé

(30) Priorität: 01.03.1990 DE 4006456; 01.03.1990 DE 4006458
(43) Veröffentlichungstag der Anmeldung: 04.09.1991
(73) Patentinhaber: BALZERS AKTIENGESELLSCHAFT, 9496 Balzers (LI)
(72) Erfinder: Bergmann, Erich, Dr., CH-8887 Mels (CH); Rudigier, Helmut, Dr., CH-7310 Bad Ragaz (CH)
(74) Vertreter: Troesch Scheidegger Werner AG

(56) Entgegenhaltungen:
- DD-A- 272 666
- DD-A- 275 883
- DD-A- 277 472
- DD-A- 279 695
- DE-A- 3 901 401
- US-A- 4 448 802
- E. Ertürk : Verschleissschutz durch TiN-Beschichtung nach dem ION BOND-Verfahren, VDI-Zeitschrift, Bd 129 (1987)
- W.M. Steen : Arc Augmented Laser Processing of Materials; J.App.Phys.51 (11) pp 5636-5641
- W. Pompe et al.: Film Deposition by laser-arcs, Thin Solid Films 208 (1992), pp. 11-14
- P. Siemroth et al.: Film Deposition by Laser Induced Vacuum Arc Evaporation, EPM 89, Abstracts

## Beschreibung

Die vorliegende Erfindung befasst sich mit einer Vorrichtung zum Verdampfen von Material im Vakuum mittels eines Lichtbogens mit einem Target, das mindestens an einem Teil seiner Oberfläche ein zu verdampfendes Material aufweist, wobei die Bogenentladung in einem Bereich betrieben wird, wo ein wesentlicher Teil des Bogenstroms meistens durch kleine Flecken auf der Targetoberfläche fliesst: mit einer Vorrichtung zum Zünden des Verdampfungslichtbogens: mit einem Verfahren gemäss dem Oberbegriff nach Anspruch 8; mit einem Verfahren zum Zünden des Lichtbogens; mit einer Plasmalichtbogenanordnung zum Auftragen von Ueberzügen auf ein Substrat mit einer Vorrichtung sowie mit einer Anwendung des Verfahrens für das Bedampfen von Substraten mittels eines Plasmalichtbogens.

Verfahren und Anlagen zum Auftragen von Ueberzügen aus relativ hochschmelzenden Materialien durch Niederschlagen des mit Hilfe eines elektrischen Lichtbogens im Vakuum verdampften Materials sind bekannt und in mannigfaltiger Weise vorbeschrieben.

Aus der DE-OS 21 36 532 ist eine Anlage bekannt, bei welcher ein elektrischer Lichtbogen zwischen einer hüllenförmigen Anode und einer, auf einem Kühlbett montierten Kathode erzeugt wird, wobei die Kathode an ihrer Oberfläche ein zu verdampfendes Metall enthält. Durch Anbringen eines Schirmes an der Kathode soll verhindert werden, dass der auf der Kathode erzeugte Kathodenfleck von der Verdampfungsfläche seitlich überspringt. Die Problematik dieser Anlage liegt darin, dass infolge des zufälligen ungeführten Wanderns des Kathodenfleckens die Kathodenoberfläche ungleichmässig abgetragen wird und zudem infolge lokaler Ueberhitzung ständig Spritzer entstehen, die zu Störungen auf der zu erzeugenden Beschichtung resp. im Ueberzug führen. Auch die US-PS 36 25 848 beschreibt eine analoge Anlage, wobei hier die Kathode aus dem Beschichtungsmaterial, das zu verdampfen ist, hergestellt ist. Die Anlage weist grundsätzlich dieselben Nachteile auf wie die Anlage gemäss DE-OS 21 36 532.

In der Anlage gemäss US-PS 4 556 471 wird mittels eines Magnetfeldes oder durch Anbringen einem Permanentmagneten versucht, den Lichtbogen so weit in seiner "Wanderung" zu beeinflussen, dass die Kathodenoberfläche oder das sogenannte Target weitgehendst gleichförmig abgetragen wird. Dabei ist die Kathode zusätzlich gegenüber der Vakuumkammer isoliert angeordnet. Grundsätzlich aber wandert der Lichtbogenfleck auf der Kathode weiterhin ungeführt und zufällig, wodurch die beschriebenen Nachteile nur teilweise behoben sind und nach wie vor die Gefahr von Spritzern bestehen bleibt. In der US-PS 4 620 913 wird eine Anlage beschrieben, wo mittels einer speziellen Anodenanordnung das Wegwandern oder das Ueberspringen des Fleckens von der Kathode verhindert werden soll. Auch die DE-OS 35 28 677 bezweckt durch das Anbringen von Lichtbogenbegrenzungsmitteln das Wegspringen des Lichtbogenfleckens, wobei hier zusätzlich durch Anbringen einer Magnetfeldquelle der Fleck eine gelenkte Bewegung auf der Kathode aufweisen soll. Durch gepulste Magnetfelderzeugung wird der Fleck je nach Polarisation veranlasst, sich in Richtung oder gegen das Magnetfeld zu bewegen. Es handelt sich dabei nur um ein "richtungsmässiges", aber nicht um ein eigentliches Führen des Fleckens, so dass - wohl etwas reduziert - immer noch die Gefahr von örtlicher Ueberhitzung und damit von Spritzern nicht vollständig behoben ist. Auch ist es nicht gelungen, Systeme dieser Art zufriedenstellend zu realisieren.

In der DE-OS 33 45 493 wird wiederum das Wegwandern des Fleckens mittels Anordnung eines Begrenzungsringes an der Kathode verhindert, jedoch ohne Beeinflussung der zufälligen Bewegung des Lichtbogenflekkens. Auch in der DE-PS 33 45 442 wird das Anbringen eines Begrenzungsringes aus einem magnetisch permeablen Material beansprucht.

In der DE-PS 31 52 131 wird in der Vakuumkammer ein Magnetfeld durch ein sogenanntes Solenoid erzeugt. Durch dieses Magnetfeld wird der Kathodenstrahlfleck zum Wandern veranlasst. Weiter ist ein Zündimpulsgenerator vorgesehen zum kontinuierlichen Zünden von Kathodenstrahlflecken, die dann infolge des Magnetfeldes zu einer Stirnfläche hinwandern. Der Fleck wird aber nicht eigentlich gesteuert, sondern nur sein Wandern vom Zufallsgenerator entlang der Kathodenoberfläche zur Stirnseite hin veranlasst.

In der CH-PS 657 242 wird beschrieben, wie die entstehenden Spritzer oder Makroteilchen im Plasma ausgeschieden werden. Angeordnet wird ein sogenannter Plasmaleiter und ein koaxial angeordneter Elektromagnet, der zu einem Fokussiersolenoid gegengeschaltet ist. Dadurch wird ein spezielles Magnetfeld erzeugt, das den Plasmastrahl derart umlenkt, dass darin enthaltene Spritzer resp. Makroteilchen aus dem Plasmaleiter ausgetrieben werden. Diese Umlenkung ist aber mit grossen Materialverlusten verbunden. Ausserdem muss der Umlenkmechanismus, der sehr viel stärker beschichtet wird als die Substrate, ständig gereinigt werden, was mit grossem Aufwand und erheblichen Umtrieben verbunden ist. Entsprechendes wird in der FR-A 2 524 254 beansprucht. Die DE-PS 32 34 100 schliesst sich im Prinzip an den Gehalt der beiden vorgenannten Dokumente an, wobei zusätzlich apparative Modifikationen vorgeschlagen werden, um eine gleichmässigere Beschichtung eines Werkstückes zu gewährleisten. Diese beziehen sich aber in keiner Weise auf das Führen des Fleckens auf der Kathodenoberfläche.

In der DE-OS 37 31 127 wird ein Lichtbogen gepulst betrieben, d.h. die Substanztemperatur wird mit einer Temperaturobergrenze verglichen, resp. bei Ueberschreiten dieser Obergrenze wird der Lichtbogen unterbrochen. Damit soll ein örtliches Ueberhitzen an der Kathodenoberfläche verhindert werden. Trotzdem entstehende Spritzer sollen mittels Anbringen von Magnetfeld/Abschirmblech abgelenkt werden, d.h., dass das Pulsen nur eine sehr ungenügende Lösung darstellt. Abschirmungen mit Magnetfeld und Blenden sind aber unwirtschaftlich, da sie einen sehr hohen Wartungsaufwand erfordern und die Beschichtungsgeschwindigkeit stark beeinträchtigen. Das beschriebene Verfahren eignet sich insbesondere für dekorative Beschichtungen und weniger für Beschichtungen im technischen Bereich.

In der US-PS 4 673 477 wird mittels eines Permanentmagneten der Kathodenfleck geführt. Die Anode ist ringförmig ausgebildet und die Kathode verschoben parallel zur Ringfläche als Scheibe ausgebildet. Hinter der Kathode ist ein Magnet angeordnet, mittels welchem der Kathodenfleck auf der Kathodenoberfläche bewegt wird. Obwohl eine Reduktion der Spritzer die Folge dieser Anordnung ist, muss die Konstruktion erneut als kompliziert bezeichnet werden.

Auch in der EP-A 0 284 145 ist die Anode ringförmig und die Kathode parallel versetzt zur Ringebene als Zylinder angeordnet, wobei letzterer um seine Achse rotierbar ist. Um ein wahlloses Wandern des Kathodenfleckes zu verhindern, ist eine Magnetanordnung vorgesehen, die innerhalb des Kathodenzylinders verschiebbar angeordnet ist. Durch Rotation des Zylinders und Längsverschiebung des Magneten wird der Kathodenfleck auf der Oberfläche geführt, um Spritzerbildung zu verhindern. Die vorgeschlagene Anordnung umfasst eine sehr komplizierte Konstruktion, die nicht als sehr praxisgerecht zu bezeichnen ist.

In den beiden vorab beschriebenen Fällen hat es sich zudem gezeigt, dass die Spritzerreduktion sehr stark vom Kathodenwerkstoff abhängt, wobei sie für die in der Praxis interessanten Werkstoffe, wie beispielsweise Titan, nicht ausreicht.

In der DE-OS-39 01 401 wird die Verwendung eines zusätzlichen gepulsten Lasers vorgeschlagen, mittels welchem eine Steuerung der Brennfleckbewegung auf der Kathode ermöglicht werden soll, um die Dropletbildung zu minimieren und die Kathodenmaterialausnutzung zu erhöhen. Die Spannung zwischen Anode und Kathode wird pulsierend angelegt und jeweils bei maximaler Spannung ein Laserimpuls, örtlich definiert, auf die Kathodenoberfläche gerichtet. Nach erfolgter zündung beginnt der Kathodenbrennfleck des Lichtbogens unter unmittelbarer Targetverdampfung seinen physikalisch bedingten unkontrollierten Weg über die Targetoberfläche.

Die Aufgabe der vorliegenden Erfindung besteht daher nach wie vor in der Forderung nach einem Verfahren resp. einer Anordnung, mittels welcher ein Funken resp. ein Lichtbogenfleck stabilisiert und gesteuert für das Verdampfen eines Beschichtungsmaterials eingesetzt wird, um die Nachteile eines ungesteuerten nichtgeführten Funkens oder Fleckens, wie oben umfangreich dargestellt, zu überwinden. Die Konstruktion und das Verfahren sollen zudem möglichst einfach sein und gegebenenfalls sogar in bestehende Anlagen zugerüstet werden können.

Erfindungsgemäss wird dies mittels einer Vorrichtung nach Anspruch 1, sowie mittels eines Verfahrens nach Anspruch 8 gelöst.

Vorgeschlagen wird eine Vorrichtung zum Verdampfen von Material mittels eines Lichtbogens im Vakuum mit einem Target, das mindestens an einem Teil seiner Oberfläche ein zu verdampfendes Material aufweist, das als Teil einer Bogenentladung geschaltet ist, wobei der Lichtbogen in einem Bereich betrieben wird, wo ein wesentlicher Teil des Bogenstroms meistens durch kleine Flecken auf der Targetoberfläche fliesst, wobei die Vorrichtung zusätzlich eine Elektronenstrahlkanone oder einen kontinuierlich betriebenen Laser beinhaltet, für das Erzeugen einer lokalen Dampfwolke auf der Targetoberfläche, um damit den Fusspunkt des Lichtbogens zu stabilisieren und zu führen, wobei im Falle eines gepulsten Lasers das Zeitintervall zwischen den Pulsen derart zu wählen ist, dass die Bogenentladung kontinuierlich brennt, um ein gleichmässiges und spritzfreies Abtragen der Targetoberfläche zu gewährleisten.

Beim Target handelt es sich vorzugsweise um die Kathode des Funkens oder Lichtbogens.

Der Laser oder der Elektronenstrahl ist bevorzugt derart aufgebaut, dass der Elektronenstrahl oder Laserstrahl auf der Targetoberfläche führbar ist. Dabei ist es beispielsweise möglich, die Objektlinse des Lasers beweglich anzuordnen oder weiter einen Spiegel vorzusehen, der für das Wandern des Brennfleckens bewegbar angeordnet ist. Gleichzeitig mit dem Führen von Elektronenstrahl oder Laserstrahl wird damit auch der Lichtbogenfleck auf der Kathodenoberfläche geführt, indem er der durch den Elektronenstrahl oder Laserstrahl erzeugten lokalen Dampfwolke auf der Targetoberfläche nachfolgt. Es ist auch möglich, das Target beweglich anzuordnen.

Ein weiteres grosses Problem, welches all den verschiedenen, zum Stande der Technik angeführten Vakuumverdampfungsanlagen resp. Verfahren gemeinsam ist, ist das Zünden eines Funkens resp. Lichtbogens. In der DE-OS 34 13 728 wird hierzu beispielsweise vorgeschlagen, dass der Lichtbogen dadurch gezündet wird, dass eine Kontaktstange oder ein Bogenzündstab, die einerseits auf der Kathodenoberfläche aufliegen und andererseits mit der Stromquelle für die Lichtbogenerzeugung verbunden sind, von der Kathodenoberfläche wegbewegt werden. Bei Eingriff des Zündstabes mit der Kathodenoberfläche besteht ein geschlossener Stromkreispfad. Bei Wegbewegen des Zündstabes springt ein Lichtbogen vom Draht auf die Kathode. Dieser Lichtbogen springt aber sofort auf die Anode über und ist somit gezündet. Die in dieser DE-OS 34 13 728 beschriebene, pneumatisch gesteuerte Konstruktion zum Führen eines Bogenzünddrahtes zur und von der Kathodenoberfläche ist kompliziert und offensichtlich sehr störungsanfällig.

Die EP-A- O 211 413 beschreibt eine ringförmige Zündvorrichtung, die um die Kathode herum angeordnet ist. Zwischen Zündringinnenkante und Targetoberfläche besteht ein kleiner Abstand, welcher für das Erzeugen des geschlossenen Stromkreises über einen dünnen Film, beispielsweise bestehend aus Titannitrid, verbunden ist. Beim Zündvorgang wird dieser dünne Film teilweise verdampft und das so ionisierte Material ermöglicht das Ueberspringen des Bogens von der Anode auf die Kathode. Beim anschliessenden Beschichtungsvorgang eines Substrates wird der Film wieder hergestellt.

Auch diese Konstruktion muss als kompliziert bezeichnet werden, und ist insbesondere aufgrund des ständigen Verdampfungs- und Wiederablagerungsprozesses des dünnen Filmes ebenfalls sehr störungsanfällig.

In der DE-OS 35 16 598 wird der Lichtbogen mechanisch gezündet, unter Verwendung eines Hebels, der in einem Faltenbalg gelagert ist. Die Konstruktion, welche an diejenige in der DE-OS 34 13 728 erinnert, ist ebenfalls kompliziert und störungsanfällig.

In der US-PS 4 612 477 erfolgt das Zünden des Lichtbogens elektrisch, unter Verwendung einer sog. Triggerelektrode, welche mit einer Funkenüberbrückungsschaltung derart verbunden ist, dass ein Durchschlagen zwischen Triggerelektrode und der Kathode in vorgegebenen Zeitintervallen stattfindet. Dieser jeweilige Spannungsunterbruch führt zur Zündung des Lichtbogens zwischen der Kathode und der Anode. Insbesondere die Ausgestaltung der Schaltung ist äusserst kompliziert.

Analog dazu erfolgt die Zündung des Funkens in der US-PS 4 673 477 durch eine Hochspannungszündeinheit ebenfalls elektrisch. Auch diese Anordnung ist kompliziert und weiter treten oft Schwierigkeiten bei der Trennung zwischen den beiden Entladungen auf.

Es ist daher vorteilhaft, eine Vorrichtung resp. eine Methode vorzuschlagen, gemäss welchen das Zünden eines Funkens resp. Lichtbogens auf einfache und auf möglichst störungsfreie Art und Weise erfolgt.

Dies wird mittels einer Vorrichtung nach Anspruch 5 gelöst.

Vorgeschlagen wird, dass die vorab beschriebene erfindungsgemässe Vorrichtung zum Zünden eines Funkens resp. des Verdampfungslichtbogens mittels der konventionellen Elektronenstrahl-Verdampferquelle resp. mittels eines geeigneten Laserstrahles verwendet wird. Dabei wird durch den Elektronen- resp. Laserstrahl die Oberfläche des Targets, welches als eine Elektrode einer Funkenquelle geschaltet ist, lokal oder über die ganze Fläche aufgeschmolzen resp. über einem kleinen Bereich der Targetoberfläche eine lokale Dampfwolke gebildet und durch Stossionisation des verdampfenden Materials mit den Elektronen des Elektronen- oder Laserstrahls eine partielle lonisierung des Dampfes erreicht. Diese ist ausreichend zur Zündung des Funkens durch Anlegen der Leerlaufspannung zwischen den beiden Elektronen des Funkens resp. Lichtbogens.

Weitere vorteilhafte Merkmale sind in den Ansprüchen 6 und 7 angeführt.

Im weiteren wird ein Verfahren zum Verdampfen eines Materials mittels eines Lichtbogens an einem Target im Vakuum vorgeschlagen, wobei das Target mindestens an seiner Oberfläche ein zu verdampfendes Material aufweist, das als Teil einer Bogenentladung geschaltet ist und wobei die Bogenentladung in einem Bereich betrieben wird, wo ein wesentlicher Teil des Bogenstroms mindestens durch kleine Flecken auf der Targetoberfläche fliesst, indem mittels eines Elektronenstrahls oder eines kontinuierlich betriebenen Lasers auf der Targetoberfläche eine lokale Dampfwolke erzeugt wird, und zwar derart, dass der Fusspunkt des Lichtbogens oder Funkens in dieser Dampfwolke stabilisiert und mit dieser geführt wird wobei im Falle eines gepulsten Lasers das Zeitintervall zwischen den Pulsen derart zu wählen ist, dass die Bogenentladung kontinuierlich brennt, um ein gleichmässiges und spritzfreies Abtragen der Targetoberfläche zu gewährleisten. Dabei ist es zusätzlich möglich, unter der Dampfwolke auf der Targetoberfläche eine Pfütze zu erzeugen.

Der Elektronenstrahl oder der Laserstrahl sind bevorzugt auf der Targetoberfläche führbar, um so den Lichtbogen resp. Funkenfusspunkt auf der Targetoberfläche zu führen. Die Führung des Elektronenstrahles oder Laserstrahles kann selbstverständlich nach einem vorgegebenen Muster erfolgen, gemäss welchem ein gleichmässiges Abtragen der Targetoberfläche durch den geführten Lichtbogen resp. Funkenfleck gewährleistet ist.

Das erfindungsgemässe Verfahren wird bevorzugt derart betrieben, dass im zeitlichen Mittel die Betriebsleistung der Bogenentladung die Betriebsleistung des Elektronenstrahls oder des Lasers übersteigt, wodurch die Verdampfung des Materials an der Targetoberfläche mehrheitlich mittels der Bogenentladung erfolgt.

Die Energiedichte des Elektronenstrahles oder Laserstrahles ist insbesondere derart geregelt, dass ein Entladungsstrom von mehr als 30 Ampère bei einer Entladungsspannung von lediglich 10 bis 15 Volt ermöglicht wird.

Weiter wird vorgeschlagen, dass der über dem Target liegende Verdampfungsraum eine verdünnte Atmosphäre aus Edelgas, Sauerstoff, Stickstoff, einer gasförmigen Kohlenstoffverbindung, einer metallorganischen gasförmigen oder borhaltigen gasförmigen Verbindung aufrechterhalten wird.

Falls die Targetoberfläche ein leicht schmelzendes Material umfasst, so wird vorzugsweise der Elektronenstrahl oder Laserstrahl so stark defokussiert, dass die Pfütze um den Lichtbogenfusspunkt der Bogenentladung ständig einen Trichter bildet, in dessen Grund immer flüssiges Targetmaterial nachrinnt, wodurch der Lichtbogen stabilisiert wird, ohne Führung.

Weiter wird vorgeschlagen, dass die Bewegung des Elektronenstrahls bzw. Laserbrennpunktes so rasch erfolgt, dass damit die Eigenbewegung des Bogenentladungsfusspunktes, wobei es sich vorzugsweise um den Kathodenfusspunkt handelt, unterdrückt wird.

Die oben erwähnten erfindungsgemässen Vorrichtungen eignen sich insbesondere für die Verwendung in einer Plasmalichtbogenanordnung zum Auftragen von Ueberzügen auf ein Substrat.

Die erfindungsgemässen Verfahren eignen sich ebenfalls zum Zünden des Verdampfungslichtbogens am Target, was mittels Elektronenstrahl oder des Lasers erfolgt. Entsprechende erfindungsgemässe Verfahren sind gemäss dem Wortlaut nach einem der Ansprüche 13 bis 15 charakterisiert.

Ebenso eignen sich die beschriebenen Verfahren zum Bedampfen von Substraten mittels eines Plasmalichtbogens im Hochvakuum.

Die erfindungsgemässen Verfahren eignen sich insbesondere zur Herstellung von Ueberzügen, bestehend aus Oxiden, Nitriden, Oxinitriden, Boriden, Carbiden und Fluoriden für optische Anwendungen durch Verdampfen eines Elementes oder einer Verbindung des entsprechenden Elementes der Gruppen 2a, 3a, 3b, 4a, 4b, 5a, 5b, 6a in einer entsprechenden Reaktivgasatmosphäre.

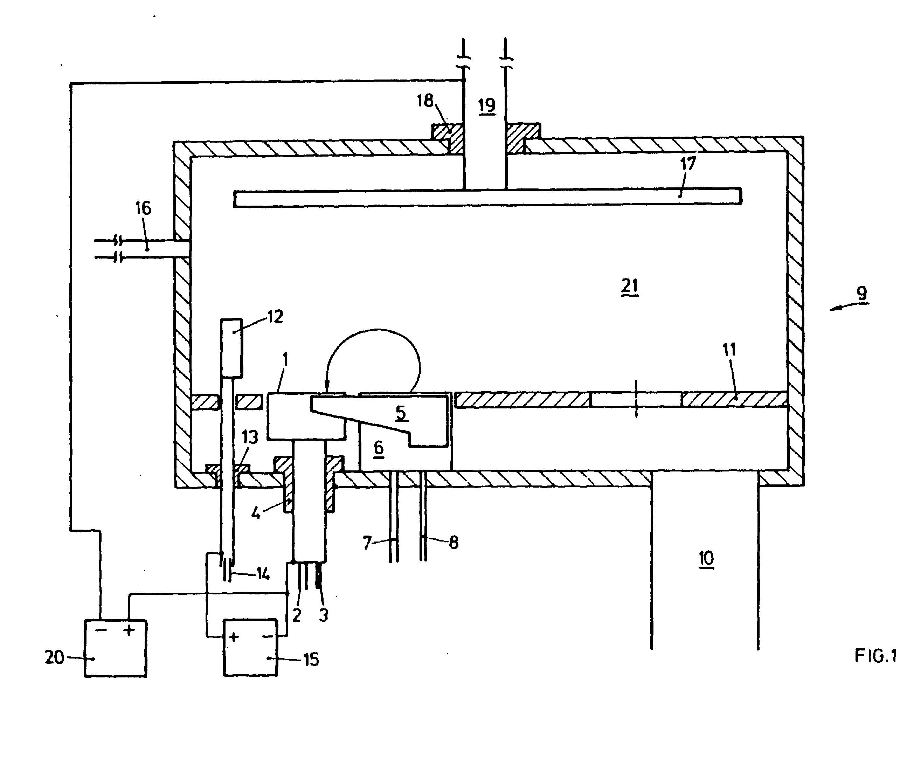

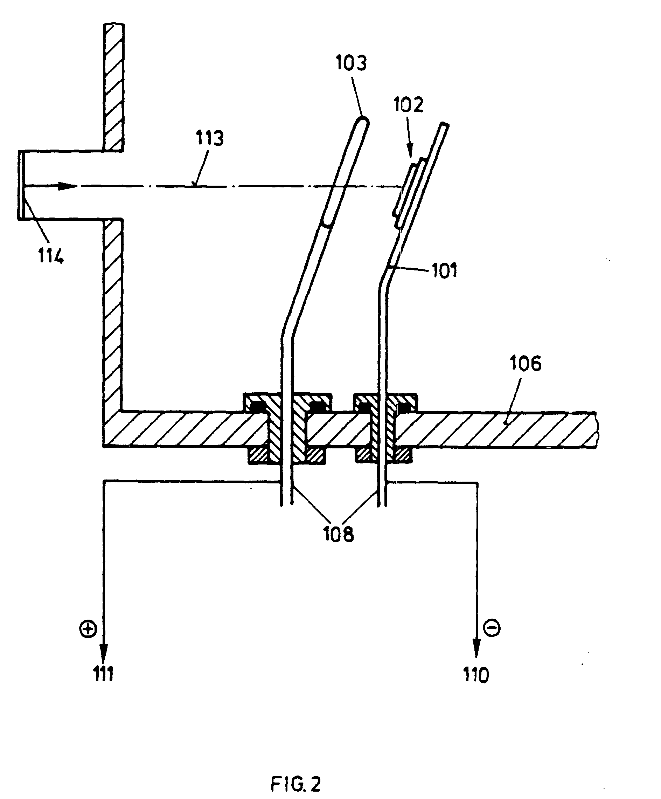

Die Erfindung wird nun anschliessend beispielsweise anhand der beigefügten Figuren und anhand von spezifischen Ausführungsbeispielen näher erläutert. Die beigefügte Fig. 1 zeigt dabei eine Hochvakuumanlage mit einer Funkenentladungsanordnung sowie eine Elektronenkanone. Fig.2 zeigt eine Prinzipskizze einer erfindungsgemässen Anlage, geeignet für die Durchführung der Beispiele 4 und 5.

In einer Hochvakuumanlage 9 mit der entsprechenden Pumpöffnung 10 für das Evakuieren der Vakuumanlage 9 ist eine konventionelle Elektronenkanone 6 montiert, welche mittels einer Wasserkühlung 7, 8 gekühlt wird. Die Elektronenkanone 6 ist derart angeordnet, dass ein von der Elektronenkanone emittierter Elektronenstrahl, geführt durch die Polschuhe eines Elektromagneten 5, auf das rotierende, durch einen Isolator 4 vom Anlagenboden isoliert montierte Target 1 trifft, das ebenfalls mittels Wasserkühlung 2,3 gekühlt wird.

Das Target 1 dient gleichzeitig als Kathode der Funkenentladung. Diese Funkenentladung umfasst eine wassergekühlte Anode 12 mit einer Wasserkühlung 14, die über einen Isolator 13 von der Anlage isoliert ist. In einer beispielsweise ausgeführten erfindungsgemässen Anordnung umfasst die Anode 12 die Ausmasse 30 x 10cm und ist in einer Entfernung von ca. 10cm vom Target 1 montiert.

Ein Zwischenboden 11 dient als Druckstufe für den Fall, dass über einen Gaseinlass 16 Reaktiv- oder Edelgase eingelassen werden, so dass der Druck in der Beschickungskammer 21 über den für die Elektronenkanone maximal zulässigen Druck steigt.

Die Schaltung 15 symbolisiert die Stromversorgung des Funkens, wobei es sich beispielsweise um einen Hochstromgenerator handeln kann. Die zu beschichtenden Gegenstände, wie beispielsweise optischen Substrate, werden auf dem rotierenden Substrathalter 17 befestigt, der über Isolierungen 18 gegenüber der Anlage isoliert ist. Die Drehdurchführung 19 ist wassergekühlt. Der Substrathalter kann mittels einer Spannungsquelle 20 auf ein gegenüber der Kathode negatives Potential gelegt werden.

Wenn nun die Hochvakuumanlage 9 in Betrieb genommen wird, wird mittels der Elektronenkanone und den Polschuhen des Elektromagneten 5 ein Elektronenstrahl auf die Oberfläche des Targets 1 geführt. Dadurch wird auf der Targetoberfläche ein punktförmiger Flecken des zu verdampfenden Materials angeschmolzen und dieses Material teilweise verdampft. Durch die Stossionisation des verdampfenden Materials mit den Elektronen des Elektronenstrahls wird eine partielle lonisierung des Dampfes erreicht. Diese lonisierung ist ausreichend zur Zündung des Funkens durch Anlegen der Leerlaufspannung zwischen den beiden Elektroden des Funkens resp. zwischen den Targets 1 und der Anode 12. Der überspringende Funken resp. Lichtbogen springt im übrigen auf den vorgeschmolzenen, punktförmigen Flecken an der Targetoberfläche.

Die Elektronenstrahlkanone 6 ist bevorzugt derart in der Hochvakuumanlage 9 angeordnet, dass der Elektronenstrahl beliebig auf der Oberfläche des Targets 1 geführt werden kann. Durch diese Bewegung kann nun auch der Lichtbogen in beliebiger Art und Weise auf der Targetoberfläche geführt werden, wodurch gleichmässiges und spritzerfreies Verdampfen des Targetmaterials möglich ist. Bei Unterbrechen des Lichtbogens wird durch das punktförmige Aufschmelzen der Targetoberfläche automatisch ein neuer Funken gezündet und der Lichtbogen aufrechterhalten. Die Beschichtung eines Substrates, welches auf der Substrathalterung 17 angeordnet ist, erfolgt gemäss allgemein bekannter Verfahrenstechniken.

Anstelle einer Elektronenkanone 6 kann selbstverständlich auch ein Laser in der Hochvakuumanlage angeordnet werden, wodurch nun die Oberfläche des Targets 1 durch einen entsprechenden Laserstrahl örtlich angeschmolzen wird. Wiederum erfolgt die Zündung des Funkens durch die notwendige lonisierung des verdampften Materials oder aber der Restgasatmosphäre in der Beschickungskammer 21. Auch bei Anbringen eines Lasers anstelle einer Elektronenstrahlkanone ist es möglich, durch Führen des entsprechenden Fleckens auf der Oberfläche des Targets nach Zünden des Lichtbogens diesen auf der Targetoberfläche zu führen, um ein gleichmässiges und spritzerfreies Abtragen der Targetoberfläche zu gewährleisten.

Die in Fig. 1 beispielsweise dargestellte Verwendung einer Elektronenstrahlkanone eignet sich zum Zünden resp. Führen eines Funkens in einer x-beliebigen Hochvakuumanlage.

### Ausführungsbeispiele:

### Beispiel 1:

Eine kubische Bedampfungsanlage vom Typ BAI 640 K wurde wie folgt ausgerüstet: In ihrem Boden, dezentriert, war ein wassergekühlter Tiegel eingebaut. Neben dem Tiegel im Boden war eine Elektronenstrahlkanone mit axialem Magnetfeld angebracht, deren Kathodenraum differentiell abgepumpt wurde. Der Abstand vom Austritt des Elektronenstrahls zum Kathodenmittelpunkt betrug 100mm. Die Elektronenstrahlkanone hatte eine maximale Leistung von 8 kW. Der Tiegel war aus Kupfer gefertigt, wassergekühlt und hatte einen Durchmesser von 80mm. Er war elektrisch sowohl vom Kammerboden als auch von der Masse der Kanone isoliert. Mit einem Elektromotor konnte er in Rotation versetzt werden. Der Tiegel wurde mit einem Kabel, das isoliert in die Anlage eingeführt worden war, an den negativen Pol eines Gleichspannungsspeisegerätes von der Art eines Schweisstransformators (max. 250 A) mit Kupferkabeln von 10mm angeschlossen. Der positive Pol des Speisegerätes wurde mit einer getrennten, elektrisch isolierten und wassergekühlten Durchführung an eine wassergekühlte Hilfsanode angeschlossen. Diese war rechteckig, 250 x 100mm, und stand wimpelartig in einem Abstand von 60mm vom Tiegel. Gegenüber dem Boden befand sich ein Drehteller, dessen Achse durch das Anlagenzentrum führte, auf dem Prüfkörper angebracht waren. Der Tiegel wurde mit 350g Titan chargiert und die Anlage geschlossen und abgepumpt. Die Prüfkörper wurden mit einer für die Werkzeugbeschichtung üblichen Methode geheizt und ihre Oberfläche in einem Argonplasma gereinigt. Danach wurde die Elektronenstrahlkanone eingeschaltet und ihre Leistung auf 700 Watt hochgefahren. Die Spannung zwischen Filament und Tiegel betrug 10.6 kV. Der Tiegel wurde mit einer Frequenz von 2 Umdrehungen/Minute in Rotation versetzt. Der Brennfleck mit einem Durchmesser von etwa 1mm wurde auf den der Austrittsöffnung des Elektronenstrahls näher liegenden Sektor des Tiegels fokussiert. Der Druck in der Kammer war kleiner als 0.002 Pa. Danach wurde der Schweisstransformator eingeschaltet. Seine Leerlaufspannung von 130 V reichte, um eine Entladung zu beenden. Der Strom wurde auf 200 A geregelt. Die Betriebsspannung betrug 41 V. In der Schmelze bildete sich ein kreisförmiger Graben, dessen Grund dem Fusspunkt des Elektronenstrahls entsprach. Ueber dieser Schmelze bildete sich ein lichtstarkes Plasma aus. Die Substrate wurden durch ein zusätzliches Speisegerät auf eine Spannung von -80 V gegenüber dem Tiegelpotential gelegt. Der lonenstrom auf dem Substratträger betrug 8 A. Ohne Schweisstransformator war der Substratstrom zu gering, um gemessen werden zu können. Nach 15 Minuten wurden die Stromversorgungen abgeschaltet und die Anlage geflutet. Auf den Substraten befand sich eine feinkristalline Schicht von 4 µm Titan. Die Oberflächenrauhigkeit der Prüfkörper blieb unverändert und entsprach einer mittleren Rauhtiefe von Ra, 0.04 µm.

### Beispiel 2:

Es wurde der gleiche Aufbau wie im Beispiel 1 benutzt. Der Tiegel wurde mit 330g Titan chargiert. Danach wurde vorerst wie in Beispiel 1 vorgegangen. Die Leistung der Elektronenstrahlkanone wurde auf 7.4 kW geregelt. Die Tegelrotation wurde nicht eingeschaltet. Der Elektronenstrahl wurde auf die Tiegelmitte fokussiert. Der Durchmesser seines Brennflecks betrug etwa 7mm. Der Elektronenstrahl wurde mit einer Automatik mit einer Frequenz von 30 Hertz gewobbelt. Danach wurde Argon, und zwar 40 standard cm³/min, eingelassen. Danach wurde der Schweisstransformator zugeschaltet und sein Strom auf 110 A hochgeregelt. Die Betriebsspannung betrug 10 V. Ueber der Schmelze bildete sich wieder ein lichtstarkes Plasma, das der Wobbelbewegung folgte. Es wurde Stickstoff zugelassen, und zwar 420 standard cm³ /min. Die Substrate wurden auf eine Gleichspannung von -20 V gelegt. Nach einer Stunde wurden die Strom- und Gasversorgungen abgeschaltet und die Anlage geöffnet. Auf den Probescheiben waren 8 µm stöchiometrisches goldfarbenes Titannitrid abgeschieden. Die Härte der Schicht betrug 2300 HV Sie wies einen ausgezeichneten Widerstand gegenüber Erosion auf. Die Prozesstemperatur hatte 220°C nicht überschritten.

### Beispiel 3:

Eine kubische Bedampfungsanlage vom Typ BAI 640 K wurde wie folgt ausgerüstet: In ihrem Boden, dezentriert, war ein wassergekühlter Tiegel eingebaut. Neben dem Tiegel im Boden war eine Elektronenstrahlkanone mit axialem Magnetfeld angebracht, deren Kathodenraum differentiell abgepumpt wurde. Der Abstand vom Austritt des Elektronenstrahls zum Kathodenmittelpunkt betrug 160mm. Die Elektronenstrahlkanone hatte eine maximale Leistung von 8 kW. Der Tiegel war aus Kupfer gefertigt, wassergekühlt und hatte einen Durchmesser von 80mm. Er war elektrisch sowohl vom Kammerboden als auch von der Masse der Kanone isoliert. Mit einem Elektromotor konnte er in Rotation versetzt werden. Der Tiegel wurde mit einem Kabel, das isoliert in die Anlage eingeführt worden war, an den negativen Pol eines Gleichspannungsspeisegerätes von der Art eines Schweisstransformators (max. 250 A) mit Kupferkabeln von 10mm angeschlossen. Der positive Pol des Speisegerätes wurde mit einer getrennten, elektrisch isolierten und wassergekühlten Durchführung an eine wassergekühlte Hilfsanode angeschlossen. Diese war rechteckig, 250 x 100mm, und stand wimpelartig in einem Abstand von 60mm vom Tiegel. Gegenüber vom Boden befand sich eine Kalotte mit Glasscheiben. Der Tiegel wurde mit 60g Silicium chargiert und die Anlage geschlossen und abgepumpt. Danach wurde in die Kammer Sauerstoff eingelassen, dessen Fluss so geregelt war, dass der Druck in der Anlage 0,09Pa nicht überstieg. Danach wurde die Elektronenstrahlkanone eingeschaltet und ihre Leistung auf 600W hochgefahren. Etwa gleichzeitig wurde der Tiegel in Rotation versetzt und der Schweisstransformator zugeschaltet. Dessen Strom wurde auf 140 Ampère hochgeregelt. Nach 30 Minuten wurde die Stromversorgung abgeschaltet. Beim Oeffnen der Anlage hat sich auf den Glasscheiben eine transparente Siliciumoxidschicht niedergeschlagen.

### Beispiel 4:

Wie in Fig. 2 als Prinzipskizze dargestellt, wurde in einer kubischen Anlage BAI 760 K, 200mm vom Anlagenzentrum entfernt, ein wassergekühlter, kreisförmiger Kathodenhalter 101 so montiert (Durchmesser 120mm, Dicke 10mm), dass der Winkel zwischen der Oberflächennormalen und der Anlagenachse 70° betrug. Auf diesen Kathodenhalter wurde ein 3mm dickes, rundes Titantarget 102 (Durchmesser 48mm), das auf einen runden (60mm Durchmesser), 12mm dicken Kupferblock aufgelötet war, derart aufgeschraubt, dass zwischen Titantarget und Kathodenhalter ein guter elektrischer Kontakt hergestellt werden konnte. Im Abstand von 35mm von der Kathode wurde eine isoliert durch den Anlagenboden 106 durchgeführte, wassergekühlte 108 ringförmige (Innendurchmesser 70mm) Anode 103 mit kreisförmigem Querschnitt (Durchmesser 12mm) parallel zur Kathode montiert. Die Kathode war geerdet und mit dem negativen Pol 110 eines Schweisstransformators (max. 250 A) verbunden, die Anode 103 wurde mit dem positiven Pol 111 dieser Stromquelle verbunden. Der Laserstrahl 113 eines gepulsten Nd:YAG Lasers (500 W) wurde durch ein Fenster 114 (Durchmesser 40mm), das beidseitig mit einer Antireflexschicht beschichtet war, in die Anlage geführt und durch die Anode hindurch auf die Kathodenoberfläche fokussiert. Der Abstand zwischen dem Fenster und der Kathode betrug 280mm. Der Laserstrahl wurde ausserhalb der Anlage mittels eines rotierenden dielektrischen Spiegels, dessen Oberfläche einen Winkel von 0,5° mit der Rotationsachse bildete, um 90° umgelenkt. Durch diese Rotation konnte der Brennfleck (Durchmesser 0.7mm) des Laserstrahles auf dem Titantarget rotiert werden. Die Rotationsgeschwindigkeit war einstellbar zwischen 0 und 6000 U/min. Die Fokussierung wurde mittels einer bikonvexen, beidseitig antireflexbeschichteten Linse mit einer Brennweite von 500mm vor dem rotierenden Spiegel bewerkstelligt.

Nach Erreichen von 2*10⁻³ Pa wurde durch Einschalten des Speisegerätes eine Spannung von 100 V zwischen Kathode und Anode gelegt. Der Funke wurde darauf mittels eines Laserpulses von 6 Millisekunden Dauer und einer Energie von 30.5 Joule gezündet. Danach lief der ungeführte Funke bei ca. 20 V und 90 A. Es wurde festgestellt, dass die Zündbedingung (Schwellenergie des Laserpulses) stark von der Oberflächenbeschaffenheit des Targets (Reflexionsvermögen) und von der Rotationsgeschwindigkeit des Laserstrahles abhängt.

Das Zeitintervall zwischen Pulsen kann so gewählt werden, dass die Bodenentladung kontinuierlich brennt. Dies erlaubt ein Führen des Funkens auf der Kathodenfläche. Anstelle des Spiegels können auch andere optische Elemente, wie Hohlspiegel oder Gitter, verwendet werden. Anstelle des Nd:YAG Lasers können auch Gas oder Halbleiterlaser verwendet werden.

### Beispiel 5:

In einer kubischen Anlage BAI 760 K wurde, 200mm vom Anlagenzentrum entfernt, ein wassergekühlter, kreisförmiger Kathodenhalter so montiert (Durchmesser 120mm, Dicke 10mm), dass der Winkel zwischen der Oberflächennormalen und der Anlagenachse 70° betrug. Auf diesen Kathodenhalter wurde ein 5mm dickes, rechteckiges Zinntarget, das auf eine Kupferplatte der Dicke 5mm aufgelötet war, derart aufgeschraubt, dass zwischen Zinntarget und Kathodenhalter ein guter elektrischer Kontakt hergestellt werden konnte. Im Abstand von 35mm von der Kathode wurde eine isoliert durch den Anlagenboden durchgeführte wassergekühlte, ringförmige (Innendurchmesser 70mm) Anode mit kreisförmigem Querschnitt (Durchmesser 12mm) parallel zur Kathode montiert.

Die Kathode (und somit das Zinntarget) war geerdet und mit dem negativen Pol eines Schweisstransformators (max. 250 A) verbunden. Die Anode wurde mit dem positiven Pol dieser Stromquelle verbunden. Der Laserstrahl eines gepulsten Nd:YAG Lasers (500 W) wurde durch ein Fenster (Durchmesser 40mm), das beidseitig mit einer Antireflexschicht beschichtet war, in die Anlage geführt und durch die Anode hindurch auf die Kathodenoberfläche fokussiert. Der Abstand zwischen dem Fenster und der Kathode betrug 280mm. Die Fokussierung des Laserstrahls erfolgte mittels einer beidseitig mit einer Antireflexschicht versehenen Linse (Brennweite 500mm), die starr mit dem Laser verbunden war. Die Bewegung des fokussierten Laserstrahles innerhalb einer Fläche von 50mm Durchmesser auf dem Target wurde bewerkstelligt, indem der Laser ausserhalb der Anlage auf einem massiven Tisch, der in zwei voneinander unabhängigen Richtungen bewegt werden konnte, montiert wurde.

Nach Erreichen von 2*10⁻³ Pa wurde Argon in die Vakuumkammer eingelassen, bis ein Druck von 2*10⁻¹ Pa erreicht wurde. Durch Einschalten des Speisegerätes wurde eine Spannung von 100 V zwischen Kathode und Anode gelegt. Der Funke konnte mittels eines Laserpulses von 6 Millisekunden Dauer und einer Energie von 2 J gezündet werden und lief auf dem Zinntarget.

Danach lief der Funke bei ca. 20 V und 90 A. Es wurde festgestellt, dass die Zündbedingung (Schwellenergie des Laserpulses) stark von der Oberflächenbeschaffenheit des Targets (Reflexionsvermögen) und, evidenterweise, von der Rotationsgeschwindigkeit des Laserstrahles abhängt.

### Beispiel 6:

In einer kubischen Anlage BAI 760 K wurde, 200mm vom Anlagenzentrum entfernt, ein wassergekühlter, kreisförmiger Kathodenhalter so montiert (Durchmesser 120mm, Dicke 10mm), dass der Winkel zwischen der Oberflächennormalen und der Anlagenachse 70° betrug. Auf diesen Kathodenhalter wurde ein 5mm dickes, rundes Wolframtarget (Durchmesser 30mm) aufgeklemmt, so dass zwischen Wolframtarget und Kathodenhalter ein guter elektrischer Kontakt hergestellt werden konnte. Im Abstand von 35mm von der Kathode wurde eine isoliert durch den Anlagenboden durchgeführte, wassergekühlte, ringförmige (Innendurchmesser 70mm) Anode mit kreisförmigem Querschnitt (Durchmesser 12mm) parallel zur Kathode montiert.

Die Kathode war geerdet und mit dem negativen Pol eines Schweisstransformators (max. 250 A) verbunden. Die Anode wurde mit dem positiven Pol dieser Stromquelle verbunden. Der Laserstrahl eines gepulsten Nd:YAG Lasers (500 W) wurde durch ein Fenster (Durchmesser 40mm), das beidseitig mit einer Antireflexschicht beschichtet war, in die Anlage geführt und durch die Anode hindurch auf die Kathodenoberfläche fokussiert. Der Abstand zwischen dem Fenster und der Kathode betrug 280mm. Die Fokussierung des Laserstrahles (Durchmesser des Laserstrahles auf dem Target: 0.65mm) erfolgte durch eine ausserhalb der Anlage montierte, beidseitig antireflexbeschichtete Bikonvexlinse (Brennweite 500mm), die so bewegt werden konnte, dass der Brennpunkt des Laserstrahles beliebig auf dem W-Target bewegt werden konnte. Die Steuerung der Bewegung erfolgte computergesteuert. Nach Ereichenvon 2*10⁻³ Pa wurde durch Einschalten des Speisegerätes eine Spannung von 100 V zwischen Kathode und Anode gelegt. Der Funke wurde darauf mittels eines treppenförmigen Laserpulses (siehe Skizze) von 3 Millisekunden totaler Dauer und einer Energie von 7.5 J gezündet. Der Funke wurde mittels eines Speicherkathodenstrahloszilloskopes aufgezeichnet. 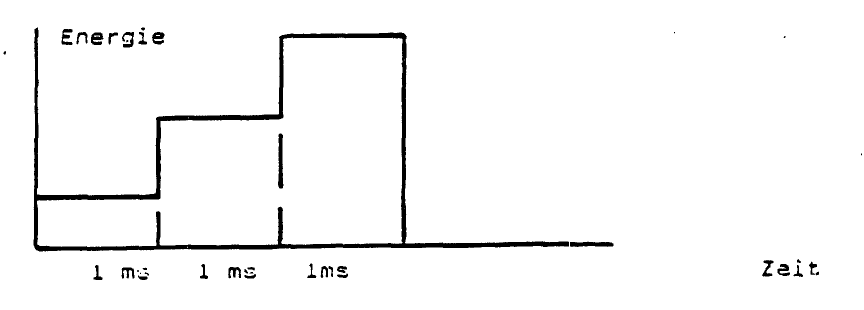 Durch ein ähnliches Vorgehen wie im Beispiel 4 oder 5 konnte der Funke kontinuierlich geführt werden.

## Patentansprüche

1. Vorrichtung zum Verdampfen von Material in Vakuum mittels eines Lichtbogens mit einem Target (1,102), das mindestens an einem Teil seiner Oberfläche ein zu verdampfendes Material aufweist, wobei die Bogenentladung in einem Bereich betrieben wird, wo ein wesentlicher Teil des Bogenstroms meistens durch kleine Flecken auf der Targetoberfläche fliesst und das Target als Kathode des Funkens oder Lichtbogens geschaltet ist, **dadurch gekennzeichnet, dass** die Vorrichtung zusätzlich eine Elektronenstrahlkanone (6) oder einen kontinuierlich betriebenen Laser (113,114) für das Erzeugen einer lokalen Dampfwolke auf der Targetoberfläche und Mittel zum Führen des Elektronenstrahls oder des Laserstrahls über die Targetoberfläche aufweist, um damit den Lichtbogenfusspunkt zu stabilisieren und zu führen,
wobei im Falle eines gepulsten Lasers das Zeitintervall zwischen den Pulsen derart zu wählen ist, dass die Bogenentladung kontinuierlich brennt, um ein gleichmässiges und spritzfreies Abtragen der Targetoberfläche zu gewährleisten.

2. Vorrichtung nach Anspruch 1, **dadurch gekennzeichnet, dass** die Objektlinse des Lasers beweglich angeordnet ist, derart, dass der Laserstrahl auf der Targetoberfläche führbar ist.

3. Vorrichtung nach einem der Ansprüche 1 oder 2, **dadurch gekennzeichnet, dass** ein bewegbarer Spiegel angeordnet ist, um zu ermöglichen, dass der Brennfleck des Lasers wandert, derart, dass der Laserstrahl auf der Targetoberfläche führbar ist.

4. Vorrichtung nach einem der Ansprüche 1 bis 3, **dadurch gekennzeichnet, dass** das Target bewegbar angeordnet ist.

5. Vorrichtung nach einem der Ansprüche 1 bis 4, zum Zünden des Verdampfungslichtbogens am Target, **dadurch gekennzeichnet, dass** die Elektronenstrahlkanone oder der Laser für das Erzeugen eines vorgeschmolzenen Fleckens resp. der Bildung einer lokalen Dampfwolke über einem kleinen Bereich der Targetoberfläche vorgesehen ist, der resp. die ausreichend ist zur Zündung des Lichtbogens.

6. Vorrichtung nach einem der Ansprüche 1 bis 5, **gekennzeichnet durch** eine Laseroptik, deren Brennweite grösser als 40 mm ist.

7. Vorrichtung nach einem der Ansprüche 5 oder 6, **gekennzeichnet durch** einen gepulsten Laser zum Zünden des Lichtbogens.

8. Verfahren zum Verdampfen von Material in Vakuum mittels eines Lichtbogens an einem als Kathode geschalteten Target (1,102), das mindestens an einem Teil seiner Oberfläche ein zu verdampfendes Material aufweist, wobei die Bogenentladung in einem Bereich betrieben wird, wo ein wesentlicher Teil des Bogenstroms meistens durch kleine Flecken auf der Targetoberfläche fliesst, **dadurch gekennzeichnet, dass** man mittels eines Elektronensträhls oder eines kontinuierlich betriebenen Lasers auf der Targetoberfläche eine lokale Dampfwolke erzeugt, derart, dass man den Fusspunkt des Lichtbogens oder des Funkens in dieser Dampfwolke stabilisiert und mit dieser führt,
wobei im Falle eines gepulsten Lasers das Zeitintervall zwischen den Pulsen derart zu wählen ist, dass die Bogenentladung kontinuierlich brennt, um ein gleichmässiges und spritzfreies Abtragen der Targetoberfläche zu gewährleisten.

9. Verfahren nach Anspruch 8, **dadurch gekennzeichnet, dass** man unterhalb der Dampfwolke auf der Targetoberfläche eine Pfütze erzeugt.

10. Verfahren nach einem der Ansprüche 8 oder 9, **dadurch gekennzeichnet, dass** man den Elektronenstrahl oder den Laserstrahl auf der Targetoberfläche führt.

11. Verfahren nach einem der Ansprüche 8 bis 10, **dadurch gekennzeichnet, dass** im zeitlichen Mittel die Betriebsleistung der Bogenentladung die Betriebsleistung der Elektronenstrahlkanone oder des Lasers übersteigt bzw. dass das Verdampfen des Materials mehrheitlich mittels des Lichtbogens der Bogenentladung erfolgt.

12. Verfahren nach einem der Ansprüche 8 bis 11, **dadurch gekennzeichnet, dass** man die Energiedichte des Elektronenstrahls oder des Laserstrahls derart regelt, dass ein Entladungsstrom von mehr als 30 Ampere bei einer Entladungsspannung von lediglich 10 bis 15 Volt ermöglicht wird.

13. Verfahren nach einem der Ansprüche 8 bis 12, **dadurch gekennzeichnet, dass** mittels der Elektronenstrahlkanone oder des Lasers auf der Targetoberfläche ein vorgeschmolzener Fleck resp. über einem kleinen Bereich der Targetoberfläche eine lokale Dampfwolke erzeugt wird, der resp. die ausreichend ist zur Zündung eines Funkens resp. des Lichtbogens.

14. Verfahren nach Anspruch 13, **dadurch gekennzeichnet, dass** die Grösse des Zündfleckens bei Verwendung eines Elektronenstrahls kleiner 10 mm², vorzugsweise kleiner als 1 mm², resp. bei Verwendung eines Lasers kleiner 0,3 mm², bevorzugt kleiner 0,1mm², gewählt wird.

15. Verfahren nach einem der Ansprüche 13 oder 14, **dadurch gekennzeichnet, dass** die Zündung des Lichtbogens wenigstens nahezu regelmässig wiederholt wird.

16. Verfahren nach einem der Ansprüche 8 bis 15, **dadurch gekennzeichnet, dass** man im über dem Target liegenden Verdampfungsraum eine verdünnte Atmosphäre aus Edelgas, Sauerstoff, Stickstoff, einer gasförmigen Kohlenstoffverbindung, einer metallorganischen gasförmigen oder einer bohrhaltigen gasförmigen Verbindung aufrechterhält.

17. Verfahren nach einem der Ansprüche 9 bis 16, **dadurch gekennzeichnet, dass** die Targetobefläche aus einem leichtschmelzenden Material besteht und man den Elektronenstrahl oder den Laserstrahl so stark defokussiert, dass die Pfütze um den Lichtbogenfusspunkt der Bogenentladung ständig einen Trichter bildet, in dessen Grund immer flüssiges Targetmaterial nachrinnt, wodurch der Lichtbogen ohne Führung stabilisiert wird.

18. Verfahren nach einem der Ansprüche 8 bis 17, **dadurch gekennzeichnet, dass** die Bewegung des Elektronenstrahls bzw. Laserbrennpunktes so rasch erfolgt, dass man damit die Eigenbewegung des Bogenentladungsfusspunktes unterdrückt.

19. Anwendung des Verfahrens nach einem der Ansprüche 13 bis 15 zum sequentiellen Zünden mehrerer Targets mit einem Strahl.

20. Anwendung des Verfahrens nach einem der Ansprüche 8 bis 18, für das Bedampfen von Substraten mittels eines Plasmalichtbogens.

21. Anwendung nach Anspruch 20, **dadurch gekennzeichnet, dass** im Aufdampfraum eine Stickstoff-, Sauerstoff- oder eine gasförmige, Kohlenstoffverbindung enthaltende Atmosphäre aufrechterhalten wird, die mit dem kondensierenden Material auf der Oberfläche wenigstens teilweise zu dessen Karbiden, Oxiden und Nitriden bzw. Mischungen derselben reagiert.

## Claims

1. Device for vaporising material in a vacuum by means of an arc with a target (1, 102) which has a material to be vaporised at least on part of its surface, where the arc discharge is operated in an area in which an essential part of the arc current flows mostly through small spots on the target surface and the target is connected as a cathode of the spark or arc, **characterised in that** the device also has an electron beam gun (6) or a continuously operated laser (113, 114) to generate a local vapour cloud on the target surface and means of guiding the electron beam or laser beam over the target surface in order to stabilise and guide the base point of the arc, where in the case of a pulsed laser the time interval between the pulses is selected such that the arc discharge burns continuously in order to guarantee an even and splash-free removal of the target surface.

2. Device according to claim 1, **characterised in that** the object lens of the laser is arranged mobile such that the laser beam can be guided on the target surface.

3. Device according to any of claims 1 or 2, **characterised in that** a movable mirror is arranged to allow the cathode spot of the laser to move such that the laser beam can be guided on the target surface.

4. Device according to any of claims 1 to 3, **characterised in that** the target is arranged movably.

5. Device according to any of claims 1 to 4 for igniting the vaporization arc on the target, **characterised in that** the electron beam gun or laser for generating a melted spot or forming a local vapour cloud is provided over a small area of the target surface which is sufficient to ignite the arc.

6. Device according to any of claims 1 to 5, **characterised by** a laser lens with a focal length greater than 40 mm.

7. Device according to any of claims 5 or 6, **characterised by** a pulsed laser to ignite the arc.

8. Device for vaporising material in a vacuum by means of an arc on a target (1, 102) connected as a cathode which has a material to be vaporised on at least one part of its surface, where the arc discharge is operated in an area where an essential part of the arc current flows mostly through small spots on the target surface, **characterised in that** by means of an electron beam or a continuously operated laser a local vapour cloud is generated on the target surface such that the base point of the arc or spark is stabilised in this vapour cloud and guided with it, where in the case of a pulsed laser the time interval between the pulses is selected such that the arc discharge burns continuously in order to guarantee an even and splash-free removal of the target surface.

9. Process according to claim 8, **characterised in that** a pool is created below the vapour cloud on the target surface.

10. Process according to any of claims 8 or 9, **characterised in that** the electron beam or the laser beam is guided on the target surface.

11. Process according to any of claims 8 to 10, **characterised in that** at the temporal middle point, the operating power of the arc discharge exceeds the operating power of the electron beam gun or laser and that the greatest part of the material is vaporized by means of the arc of the arc discharge.

12. Process according to any of claims 8 to 11, **characterised in that** the energy density of the electron beam or laser beam is controlled such that a discharge current of over 30 Ampere is possible with a discharge voltage of only 10 to 15 Volt.

13. Process according to any of claims 8 to 12, **characterised in that** by means of the electron beam gun or laser a melted spot is generated on the target surface or a local vapour cloud over a small area of the target surface which is sufficient to ignite a spark or the arc.

14. Process according to claim 13, **characterised in that** the size of the ignition spot when an electron beam is used is less than 10 mm², preferably less than 1 mm², or when a laser is used less than 0.3 mm², preferably less than 0.1 mm².

15. Process according to any of claims 13 or 14, **characterised in that** the ignition of the light arc is repeated at least almost regularly.

16. Process according to any of claims 8 to 15, **characterised in that** in a vaporization chamber lying above the target, a diluted atmosphere of inert gas, oxygen, nitrogen, a gaseous carbon compound, a metal organic gaseous or a boron-containing gaseous compound is maintained.

17. Process according to any of claims 9 to 16, **characterised in that** the target surface consists of an easily melting material and the electron beam or laser beam is defocussed so strongly that the pool around the arc base of the arc discharge gradually forms a hopper into the base of which runs fluid target material such that the arc is stabilised without guidance.

18. Process according to any of claims 8 to 17, **characterised in that** the electron beam or laser cathode spot is moved so quickly that the self-generated movement of the arc discharge base point is suppressed.

19. Use of the process according to any of claims 13 to 15 for sequential ignition of several targets with one beam.

20. Use of the process according to any of claims 8 to 18, to vaporise substrates by means of a plasma arc.

21. Use according to claim 20, **characterised in that** in the vaporization chamber is maintained a nitrogen, oxygen or gaseous carbon compound-containing atmosphere which reacts with the condensing material on the surface at least partly to form its carbides, oxides and nitrides or mixtures thereof.

## Revendications

1. Dispositif pour l'évaporation d'un matériau sous vide à l'aide d'un arc électrique, avec une cible (1, 102) qui présente au moins sur une partie de sa surface un matériau à évaporer, la décharge en arc étant activée dans une zone où une partie essentielle du courant d'arc s'écoule le plus souvent par des petites taches sur la surface de la cible, et la cible étant montée comme cathode de l'étincelle ou de l'arc électrique, **caractérisé en ce que** le dispositif comporte en outre un canon électronique (6) ou un laser (113, 114) fonctionnant en continu et destiné à produire un nuage de vapeur local sur la surface de la cible, et des moyens pour guider le faisceau électronique ou le faisceau laser sur la surface de la cible afin de stabiliser et de guider ainsi la racine de l'arc électrique, étant précisé que dans le cas d'un laser impulsionnel, l'intervalle de temps entre les impulsions peut être choisi pour que la décharge en arc brûle en continu, afin de garantir un enlèvement de matière régulier et sans projections sur la surface de la cible.

2. Dispositif selon la revendication 1, **caractérisé en ce que** la lentille-objet du laser est mobile, de sorte que le faisceau laser est apte à être guidé sur la surface de la cible.

3. Dispositif selon la revendication 1 ou 2, **caractérisé en ce qu'**on prévoit un miroir mobile pour permettre au foyer du laser de se déplacer, de sorte que le faisceau laser est apte à être guidé sur la surface de la cible.

4. Dispositif selon l'une des revendications 1 à 3, **caractérisé en ce que** la cible est mobile.

5. Dispositif selon l'une des revendications 1 à 4 pour enflammer l'arc électrique d'évaporation au niveau de la cible, **caractérisé en ce que** le canon électronique ou le laser est prévu pour produire une tache pré-fondue ou pour former sur une petite zone de la surface de la cible un nuage de vapeur local qui sont suffisants pour enflammer l'arc électrique.

6. Dispositif selon l'une des revendications 1 à 5, **caractérisé par** un système optique laser dont la distance focale est supérieure à 40 mm.

7. Dispositif selon la revendication 5 ou 6, **caractérisé par** un laser impulsionnel destiné à enflammer l'arc électrique.

8. Procédé pour l'évaporation d'un matériau sous vide à l'aide d'un arc électrique au niveau d'une cible (1, 102) qui est montée comme cathode et qui présente au moins sur une partie de sa surface un matériau à évaporer, la décharge en arc étant activée dans une zone où une partie essentielle du courant d'arc s'écoule le plus souvent par des petites taches sur la surface de la cible, **caractérisé en ce qu'**on produit sur la surface de la cible, à l'aide d'un canon électronique ou d'un laser fonctionnant en continu, un nuage de vapeur local, de sorte qu'on stabilise la racine de l'arc électrique ou de l'étincelle dans ce nuage de vapeur et qu'on la guide avec celui-ci, étant précisé que dans le cas d'un laser impulsionnel, l'intervalle de temps entre les impulsions peut être choisi pour que la décharge en arc brûle en continu, afin de garantir un enlèvement de matière régulier et sans projections sur la surface de la cible.

9. Procédé selon la revendication 8, **caractérisé en ce qu'**on produit une flaque au-dessous du nuage de vapeur formé sur la surface de la cible.

10. Procédé selon la revendication 8 ou 9, **caractérisé en ce qu'**on guide le faisceau électronique ou le faisceau laser sur la surface de la cible.

11. Procédé selon l'une des revendications 8 à 10, **caractérisé en ce que** dans une moyenne temporelle, la puissance de service de la décharge en arc dépasse celle du canon électronique ou du laser et **en ce que** l'évaporation du matériau a lieu en grande partie à l'aide de l'arc électrique de la décharge.

12. Procédé selon l'une des revendications 8 à 11, **caractérisé en ce qu'**on règle la densité d'énergie du faisceau électronique ou du faisceau laser de manière à permettre un courant de décharge de plus de 30 A pour une tension de décharge de 10 à 15 V seulement.

13. Procédé selon l'une des revendications 8 à 12, **caractérisé en ce qu'**on produit sur la surface de la cible, à l'aide du canon électronique ou du laser, une tache pré-fondue ou, sur une petite zone de la surface de la cible, un nuage de vapeur local qui sont suffisants pour enflammer une étincelle ou l'arc électrique.

14. Procédé selon la revendication 13, **caractérisé en ce que** la taille choisie pour la tache d'inflammation est inférieure à 10 mm² et de préférence inférieure à 1 mm², si on utilise un canon électronique, et inférieure à 0,3 mm², de préférence inférieure à 0,1 mm², si on utilise un laser.

15. Procédé selon la revendication 13 ou 14, **caractérisé en ce que** l'inflammation de l'arc électrique est renouvelée au moins à peu près régulièrement.

16. Procédé selon l'une des revendications 8 à 15, **caractérisé en ce qu'**on maintient dans l'espace d'évaporation situé au-dessus de la cible une atmosphère raréfiée composée de gaz rares, d'oxygène, d'azote, d'un composé carboné gazeux et d'un composé gazeux organométallique ou boré.

17. Procédé selon l'une des revendications 9 à 16, **caractérisé en ce que** la surface de la cible se compose d'un matériau facilement fusible et on défocalise tellement le faisceau électronique ou le faisceau laser que la flaque formée autour de la racine de la décharge en arc forme en permanence un entonnoir au fond duquel le matériau liquide de la cible coule toujours, ce qui stabilise sans guidage l'arc électrique.

18. Procédé selon l'une des revendications 8 à 17, **caractérisé en ce que** le déplacement du faisceau électronique ou du foyer laser a lieu tellement rapidement qu'on atténue ainsi le déplacement propre de la racine de la décharge en arc.

19. Application du procédé selon l'une des revendications 13 à 15 pour enflammer de façon séquentielle plusieurs cibles avec un faisceau.

20. Application du procédé selon l'une des revendications 8 à 18 pour la métallisation sous vide de substrats à l'aide d'un jet de plasma.

21. Application selon la revendication 20, **caractérisé en ce qu'**une atmosphère contenant un composé d'azote ou d'oxygène ou un composé carboné gazeux est maintenue dans l'espace de métallisation sous vide, laquelle atmosphère réagit au moins partiellement avec le matériau qui se condense, sur la surface, pour produire des carbures, oxydes et nitrures dudit matériau ou des mélanges de ceux-ci.
